# EUROPEAN PATENT SPECIFICATION

(11) **EP 3 338 271 B1**
(45) Date of publication and mention of the grant of the patent: **07.06.2023**
(21) Application number: 16837890.9
(22) Date of filing: 19.08.2016
(51) Int. Cl.: G09F 9/37

(54) **DISPLAYS INTENDED FOR USE IN ARCHITECTURAL APPLICATIONS**
ZUR VERWENDUNG IN ARCHITEKTONISCHEN ANWENDUNGEN BESTIMMTE ANZEIGEN
DISPOSITIFS D'AFFICHAGE À UTILISER DANS DES APPLICATIONS ARCHITECTURALES

(30) Priority: 19.08.2015 US 201562207066 P
(43) Date of publication of application: 27.06.2018
(73) Proprietor: E Ink Corporation, Billerica, Massachusetts 01821-4165 (US)
(72) Inventor: PAOLINI, Richard J., Jr., Framingham, Massachusetts 01702 (US); TAUSSIG, Carl, Woodside, California 94061 (US); BISHOP, Seth J., Framingham, Massachusetts 01701 (US); MARCOLIN, David Victor, Coquitlam, BC V3B 0N2, Massachusetts 01803 (CA); DEWITTE, Russell J., Mendon, Massachusetts 01756 (US)
(74) Representative: Kilburn & Strode LLP
(86) International application number: PCT/US2016/047702
(87) International publication number: WO 2017/031398

(56) References cited:
- CN-U- 202 969 165
- JP-A- 2013 195 460
- US-A- 6 057 814
- US-A1- 2002 021 270
- US-A1- 2005 122 284
- US-A1- 2006 107 616
- US-A1- 2014 300 651
- US-B1- 6 252 564

## Description

This invention relates to displays intended for use in architectural applications, and to buildings incorporating such displays.

The recent development of low power bistable displays which are light in weight has led to consideration of the use of such displays on buildings and similar structures to allow changes in the appearance of the buildings, either for esthetic purposes or to control energy absorption and reflection. However, constructing displays which can cover the whole or a substantial portion of the external surface of a large building is attended with numerous difficulties. If a building is hundreds or thousands of feet in length, making a display on that scale as a single element is nearly impossible, and even making a static display or artwork of that scale is difficult time consuming and expensive. Accordingly, such a large display needs to be divided up into sections and assembled together with coordination among the different sections of the display. In constructing large (billboard sized) LED displays it is known to make smaller display sections which need to be assembled on a large mechanical frame to create the whole billboard sized display with many wires connected to each display section to coordinate the operation of the billboard display sections. This method of creating large displays results in a thick, heavy display, requires numerous long runs of electrical wiring, and consumes a lot of power. For displays covering architectural elements, like buildings, hundreds or thousands of feet in length, many stories tall, requiring low resolution, to show pattern changing content and not alphanumeric information display, it would be advantageous to devise a thinner, lightweight, structure that would not require complex and expensive electrical and signal wiring, and could be integrated with the architecture without heavy and bulky structural members. This invention seeks to provide such a structure.

US 2006/0107616 A1 describes a programmable window intended to cover the facade of a building Natural lighting profiles are affected in the building facade using a transparent sheet having one or more pixel elements, each pixel elements being driven to control opacity (by shading). A programmable controller is used to send control commands to control opacity of the pixel elements, wherein the percentage of light transmitted through the display panel forming part of the facade is controlled via the controller.

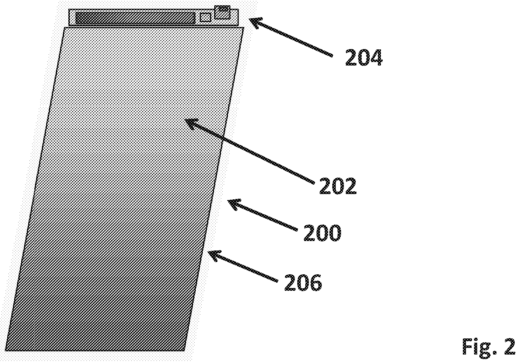

JP 2013-195460 A describes an electronic paper member intended to be used as part of an advertising medium in an outdoor environment. As illustrated in Figure 2 of this application, the electronic paper member comprises a waterproof housing, a bistable bichromal rotating ball electro-optic medium enclosed within and visible through the housing, two electrodes enclosed within the housing and arranged to apply an electric field to the electro-optic medium, a power generating means enclosed within the housing, and display drive means arranged to receive power from the power generating means and to control the potentials of the electrodes.

In one aspect this invention provides a display generally similar to that described in the aforementioned JP 2013-195460 A and as set out in the appended set of claims.

The term "weatherproof' housing is used herein in its conventional meaning of a housing which isolates the components within the housing from the effects of weather outside the housing. The weatherproof housing should at least protect its internal components from the effects of rain and dust incident upon the housing. Depending upon the climate in which the display is to be used, the weatherproof housing may have additional properties; for example in cold climates, it should protect the internal components from the effects of frost, snow or ice present on the exterior of the housing, while in climates susceptible to sandstorms, the weatherproof housing should desirably be resistant to the corrosive effect of windblown sand to avoid the view of the electro-optic medium being obscured by damage to the housing.

The terms "bistable" and "bistability" are used herein in their conventional meaning in the art to refer to displays comprising display elements having first and second display states differing in at least one optical property, and such that after any given element has been driven, by means of an addressing pulse of finite duration, to assume either its first or second display state, after the addressing pulse has terminated, that state will persist for at least several times, for example at least four times, the minimum duration of the addressing pulse required to change the state of the display element. It is shown in U.S. Patent No. 7,170,670 that some particle-based electrophoretic displays capable of gray scale are stable not only in their extreme black and white states but also in their intermediate gray states, and the same is true of some other types of electro-optic displays. This type of display is properly called "multi-stable" rather than bistable, although for convenience the term "bistable" may be used herein to cover both bistable and multi-stable displays.

An external surface of the weatherproof housing may be equipped with an adhesive layer capable of attaching the display to a surface of a building. The power generating means, which may be a photovoltaic cell, may include power storage means, such as a rechargeable battery, to allow the display to continue to function during periods of darkness or other times when the power generating means is not generating sufficient power for the requirements of the display.
Figure 1 of the accompanying drawings is a front elevation of a first display which is not a display of the present invention but which illustrates certain features which can be used in displays of the present invention.
Figure 2 is a front elevation, similar to that of Figure 1, of a second display which is not a display of the present invention but which illustrates certain features which can be used in displays of the present invention.
Figure 3 is a schematic cross-section through a portion of the display shown in Figure 2.
Figure 4 is an enlarged cross-section through the front protective sheet shown in Figure 3.
Figure 5 is an enlarged front elevation of the electronics portion of the display shown in Figure 2.
Figure 6 is a schematic rear elevation of the display shown in Figure 1 illustrating the adhesive pad used to attach the display to a building.
Figures 7A-7C are schematic illustrations of three network arrangements which may be used to pass data to individual displays in display systems of the present invention.
Figure 8 is a front view of part of a display of the present invention which uses a two-part weatherproof envelope.

As indicated above, the present invention provides a display which can be attached to an exterior surface of a building to allow changing the appearance of the building. (A display system of the present invention may additionally include displays on the interior surfaces of the building; for example, when used in a parking garage, a display system could include displays on the interior surfaces of the garage to provide variable traffic signs.)

The displays and systems of the present invention are primarily, although not exclusively intended for use with electrophoretic media. Electrophoretic media provide some unique and beneficial features that allow construction of very large displays that address many of the aforementioned issues and enable an architecture well suited for architectural displays of extremely large sizes. The bistability of electrophoretic media allows for low power operation and eliminates the need for wired connection to electrical outlets. The bistability and resultant image persistence of the display can make the power consumption of the display so low that the display can be powered by renewable power harvesting, such as solar cells, or radio frequency (RF) harvesting, depending on the update rate of the display medium and the area ratio of the solar cell or RF collection antenna to the optically active portion of the display. The solar cell is likely to be an optically inactive area of the display and should be as small as possible given the update rate that is desired. For updates limited to one image update every 10 seconds or less, the solar cell can be 5% or less of the electrophoretic medium area or approximately a 20:1 ratio of optically active medium to solar panel. There are some new technologies for making visible transparent solar cells that harvest UV and IR which could utilize the entire area of the display for power harvesting but those are not yet commercial.

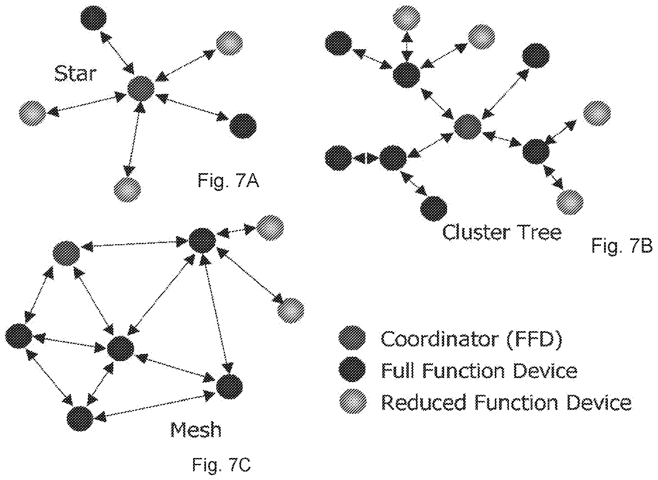

Another advantage of electrophoretic displays is that they can constructed on thin and flexible substrates. The ability to construct displays on thin plastic substrates means that the media can also be made very thin and lightweight in comparison to light emitting diode (LED) or liquid crystal (LCD); the electrophoretic media can even be made flexible and conformal. Since the medium can be made thin and lightweight, it can be applied directly to a building facade with a simple construction adhesive and does not need heavy mechanical structures or frames to build the individual display into a larger display system. If the control signals for the display system are passed to the individual displays (hereinafter referred to as "tiles") using wireless communication, for example wi-fi, each tile can function in a completely autonomous manner without any need for wires or other connection to other tiles. Depending on the construction materials to which the tiles are adhered, the selection of the transmitter for the wireless connection may critical. For example, if the building material is concrete with metal reinforcing rods ("re-bar"), a special hemispherical antenna (as illustrated in Figure 7) may be necessary for the wireless communication to function correctly despite the tiles' proximity to a large amount of re-bar. Use of the wireless communication allows for a fully sealed weatherization envelope with no penetrations at all. This is very important to minimize the penetration of water into either the display medium or the control electronics.

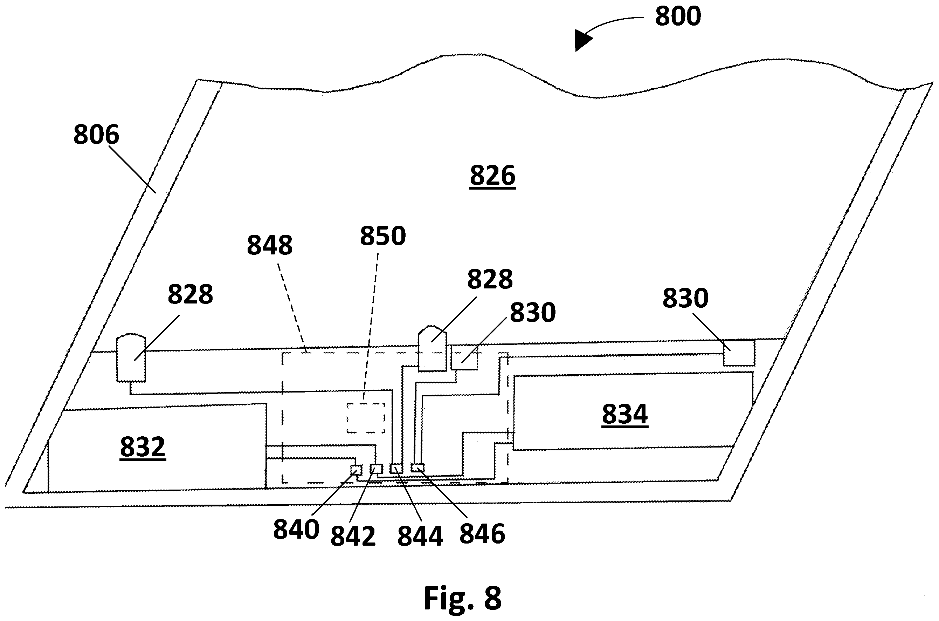

The weatherproof housing conforms closely to the components therein, such that no air gap of more than about 5 mm, and desirably no air gap of more than about 1 mm, exist between the weatherproof housing and its contents. Sections of weatherproof housing which do not closely conform to their contents tend to be more susceptible to mechanical damage. However, providing a closely conformal housing tends to be complicated by the fact that the printed circuit board typically used as a base for the display drive means and the power storage means (if present) is normally substantially thicker that the remaining components of the display. Accordingly, the weatherproof housing is formed in two section, a main (relatively thin) section which houses the display and the power generation means, and a thicker section, typically in the form of a printed circuit board, housing at least the display drive means. In one form of such a housing, as illustrated in Figure 8, a limited number of exposed contacts are provided on the first section, and the second section provides conductors which make electrical contact with the exposed contacts. The second section of the weatherproof housing covers the exposed contacts and may have the form of "potting" (in the sense of covering with a polymeric material which is then cured to cover a hard covering) the printed circuit board. An antenna or similar data receiving device may protrude from the potting material to enhance reception of data by the tile.

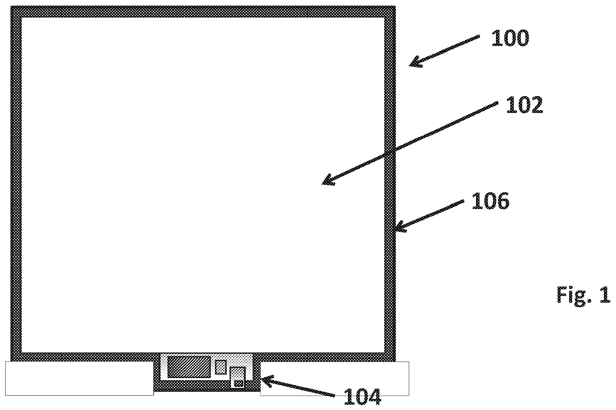

The tiles of the present invention can have many different sizes and shapes for the optically active area (i.e., the portion of the display in which the electro-optic medium is visible), and two examples will now be described with reference to Figures 1 to 5. Figure 1 is a front elevation of a first tile (generally designated 100) with a square optically active area 102 and a small, optically inactive electronics area 104 arranged along the lower edge (as illustrated) of the optically active area 102. An edge seal area 106 surrounds both the optically active area 102 and the electronics area 104; as described in more detail below, in the edge seal area 106, the front and rear protective stacks are sealed to one another, thus forming a weatherproof enclosure completely surrounding the other components of the tile.

The second tile 200 shown in Figure 2 is generally similar to that shown in Figure 1 except that its optically active area 202 has the form of a parallelogram rather than a square and its electronics area 204 is larger and provided at the upper edge (as illustrated) of the optically active area 202. Again, an edge seal area 206 surrounds both the optically active area 202 and the electronics area 204 to form a weatherproof enclosure completely surrounding the other components of the tile.

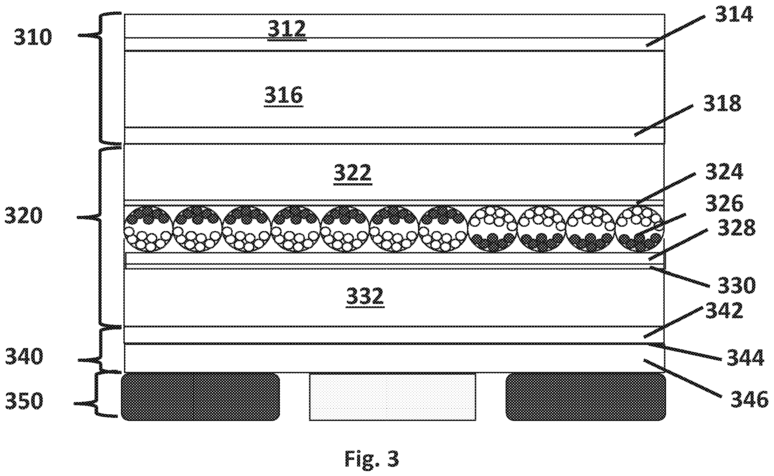

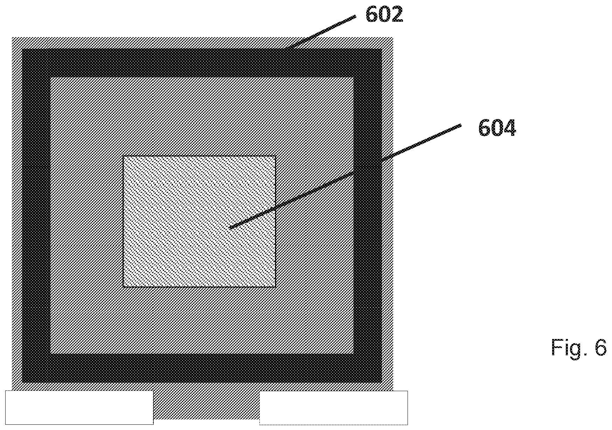

The overall structure of the tiles 100 and 200 is most easily appreciated from Figure 3, which shows a schematic cross-section through a central portion of the optically active area 202 of tile 200; tile 100 comprises the same series of layers. As shown in Figure 3, each tile comprises three main series of layers ("stacks"), namely:
1.) A viewing side or front protective stack (generally designated 310) comprising
   a. a transparent viewing side weatherization layer 312 to protect the internal components of the tile from rain or submersion in water
   b. a transparent adhesive layer 314 for lamination of the weatherization layer 312 to a UV and moisture barrier layer;
   c. a transparent viewing side ultraviolet (UV) and moisture vapor barrier layer 316; and
   d. a transparent adhesive 318 for lamination of the barrier layer 316 to the electrophoretic medium stack described below;
2.) An electrophoretic medium stack (generally designated 320) comprising
   a. a transparent front substrate 322;
   b. a transparent front electrode 324;
   c. a layer of solid electro-optic material 326, illustrated as an encapsulated electrophoretic medium;
   d. a layer of lamination adhesive 328;
   e. a backplane or rear electrode 330, which may or may not be transparent depending upon the intended use of the tile; and
   f. a rear transparent substrate 332;
3.) A backplane side or rear protective stack (generally designated 340) comprising
   a. an adhesive layer 342 for attaching the rear protective stack 340 to the electrophoretic medium stack 320;
   b. a moisture vapor barrier layer 344; and
   c. a weatherization film 346 to protect the tile from rain or submersion in water.
The tile further comprises an adhesive section 350, used to attach the tile to a building facade or other structural feature; this adhesive section 350 will be described in more detail below with reference to Figure 6.

In a preferred embodiment of the tile of the present invention, the details of the various layers shown in Figure 3 are as follows. The front protective stack 310 larger in size than the electrophoretic medium stack 320 to allow the formation of a pinched edge seal in combination with the rear protective stack in order to provide the edge seal area 206 (Figure 2). In the tile 200 shown in Figures 2 and 3, the front protective stack 310 extends 1 cm beyond the peripheries of both the electrophoretic medium stack 320 and the electronics area 204, and the same is true in Figure 1. In an alternative embodiment the weatherization layer 312 and its associated adhesive layer 314 extend beyond the edges of the barrier layer 316, which itself extends beyond the edges of the electrophoretic medium stack 320, thus permitting the formation of a first pinched edge seal between the front and rear weatherization films 312 and 346, and a second pinched seal between the front and rear barrier films 316 and 344.

In this preferred embodiment, the front weatherization layer 312 is a 50 µ film of poly(ethylene tetrafluoroethylene) (ETFE) with one surface of the film (that facing the adhesive layer 314) provided with an adhesion promotion treatment. Such ETFE are available commercially, for example from St. Gobain. The adhesive layer 314 is a pressure sensitive adhesive (PSA) from example 8171 OCA from 3M Corporation. This material is of high transparency and can be laminated at room temperature. Alternatively, a hot melt adhesive, for example Bemis EVA, can be used; hot melt adhesives tend to be slightly lower cost than PSA's but require higher temperatures for lamination.

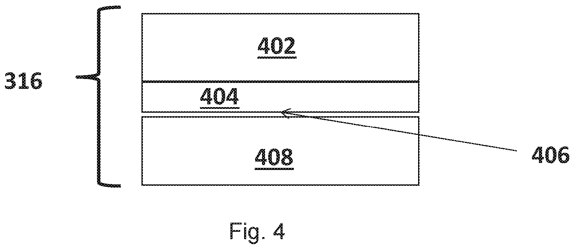

The front barrier layer 316 is itself a multi-layer stack, of which a schematic cross-section in Figure 4. As shown in that Figure, the barrier layer 316 comprises, in order from the adhesive layer 314, a front UV barrier poly(ethylene terephthalate) (PET) film 402, a layer of optically clear adhesive 404, a sputtered barrier layer 406, typically indium tin oxide (ITO), and a rear UV barrier PET film 408. Alternatively various multi-layer proprietary materials may be used, for example Konica Minolta KMBD07-07, or 3M Ultrabarrier. Another alternative is a single layer of fluorinated ethylene propylene (FEP). The adhesive layer 318 may use any of materials already described for use in adhesive layer 314.

The front substrate 322 and front electrode 324 are both formed from a 5 mil (127 µm) ITO-coated PET film; other thickness of PET and possibly other polymers can be used. The ITO layer typically has a conductivity of about 5000 Ohm/square, but lower and higher conductivities can be used. Too low a conductivity tends to lead to problems with continuity and reliability of conductivity, while too high a conductivity (i.e., too thick an ITO layer) results in excessive light loss in the ITO layer. Other clear conductors, such as PEDOT, CNT, graphene, and nanowires, could be substituted for the ITO front electrode. The electrophoretic layer 326 may be any of the electrophoretic media described in the E Ink patents and applications mentioned below. The adhesive layer 330 is a custom polyurethane latex adhesive doped with an imidazolium hexafluorophosphate dopant to control electrical properties, essentially as described in United States Patent No. 8,446,664. The rear electrode 330 and rear substrate 332 can be formed from the same PET/ITO film as the front substrate 322 and front electrode 324; alternatively, the rear electrode 330 could be a printed carbon conductor if a single pixel covering the entire display area is required, or another low cost transparent or non-transparent conductor.

The adhesive layer 342 may use any of materials already described for use in the adhesive layers 314 and 318. The adhesive layer 314 need not be transparent if the electro-optic layer 326 is of a reflective type, since the adhesive layer 342 is behind the optically active layer, as viewed from the viewing surface (the surface of the front weatherization layer 312) of the tile. In actual practice, the functions of the barrier layer 344 and weatherization layer 346 shown in Figure 3 can both be handled by a single commercial film, in the form of a 50 µm metallized PET barrier material, for example that made by Nitto Denko. This film is opaque but this is acceptable provided the electro-optic layer 326 is reflective and the layer 344 and 346 lie behind the electro-optic layer. Alternatively, many commercial fluoropolymer films can be used.

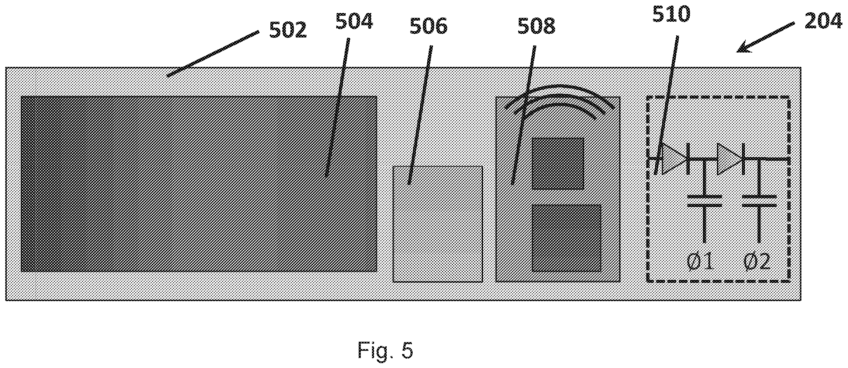

Figure 5 is an enlarged front elevation of the electronics area 204 of the tile 200 shown in Figure 2. The electronic area 204 is formed on a single printed circuit board (PCB) 502; alternatively, multiple PCBs may be used for spatial or signal quality considerations. All the elements of the electronics are full enclosed by the weatherization layers 312 and 346 (Figure 3). As shown in Figure 5, there are mounted on the PCB 502, a solar (photovoltaic) cell 504, an energy storage device 506, a wireless data receiver and transmitter 508 and a display driver/charge pump 510.

The solar cell 504 is preferably a flexible solar cell, such as a Power Film MP3-37 Flexible A-Si cell, which gives high efficiency in the low light conditions. Numerous other sizes and shapes of solar cell can be used depending upon the size and shape of the tile. Choosing a flexible solar cell also allows the tiles to be flexible including the electronics package. There are many commercial solar options to choose from in addition to the flexible ones. Alternatively, other power harvesting options, such as RF harvesting, can be used.

The energy storage device 506 poses difficult design considerations in view of the need for high energy density, high temperature performance, and (say) 10 year minimum lifetime. Options include primary batteries, rechargeable batteries, and supercapacitors, with supercapacitors generally for a balance of properties. The supercapacitor is the lowest energy of the options for power harvesting but a 2-5 farad supercapacitor coupled with a solar cell will typically provide enough power to meet the power demands of a tile overnight. The supercapacitor option has the best high temperature performance and is capable of the most charge and discharge cycles of all of the options. A combination of a supercapacitor and a solar cell provides potentially indefinite working lifetime. If a combination of solar cell and supercapacitor is unable to provide sufficient power for operation in a particular location, a rechargeable battery may be substituted. Rechargeable batteries with high energy densities, such as lithium ion batteries, can be dangerous at high temperature. Primary cell batteries can power the tiles but inevitably limit the working lifetime of a tile.

The data transmitter/receiver 508 must be of low power to operate within the power budget available from the solar cell 502. Many commercial transceivers can be used, for example a 2.4GHz System-On-Chip transceiver by Dust Networks from Linear Technology. The LTC5800 family of transceivers was used because of the low transmit/receive power, and its ability to implement a mesh network topology. Other technology choices exist for low power mesh transceivers, such as the Bluetooth Low energy chipset from Nordic Semiconductor; the nRF51822.

The display driver/charge pump 510 may be, for example, an Ultrachip UC8111, 96 segment driver with integrated charge pump. This chip can generate ±15V and 0V. There are many alternative driver chips commercially available and known to be capable of driving electrophoretic and similar media. Another alternative is a 10 stage discrete charge pump but this option tends to expensive.

Figure 6 is a rear elevation of a tile similar to the tile 100 shown in Figure 1 and illustrates an adhesive section similar to the adhesive section 350 shown in Figure 3. As shown in Figure 6, two separate adhesive areas are present on rear surface of the tile. A 2 inch (51 mm) border 602 extending around the periphery of the tile is formed from a PSA construction adhesive called BITE Mastosplice which is a butyl rubber product tape product. This tape is used to create a perimeter of adhesive around the rear surface of the tile and adheres instantly and well to concrete and other building materials at room temperature with minimal pressure. A central area 604 of adhesive is formed from Sikaflex 11FC which is a dispensed liquid construction adhesive that cures to very high adhesion strength but is not instantly self-supporting and takes 30 to 60 minutes to cure enough to be sure to be self-supporting. This combination of adhesives is since the PSA adhesive at 602 sticks instantly and may be strong enough on its own to support the weight of the tile but the adhesive at 604 when cured is much stronger and results in a stronger attachment of the tile. However, in some cases, the adhesion of liquid construction adhesive may be so strong that if removal of the tile is attempted after the construction adhesive has cured, serious damage to the surface to which the tile is attached may result. Hence, at least in some cases, it may be desirable to omit the liquid adhesive and provide additional areas of adhesive tape to attach the tile to a building or other structure.

Depending on the construction materials that the tiles are adhered to, the selection of the transmitter for the wireless antenna also becomes critical. For example, if the building material is concrete with re-bar then a special hemispherical antenna may be necessary to function properly with all of the re-bar in close proximity. Suitable antennae are available commercially, for example the Taoglas Model SWLP-12 antenna, manufactured by Taoplas of Enniscorthy, County Wexford, Ireland; a specification for this antenna can be found at https://taoglas.com/images/product_images/original_images/-SWLP.2450.12.4.B.02%20SMD%202.4%20GHz%20Patch%20Antenna%20140110.pdf. Such antennae typically use a metallic backplane to cause radiation to be emitted in a substantially hemispherical pattern, thus avoiding excessive absorption of the signal by metal present within the building structure.

Display systems of the present invention will typically use one central unit or coordinator arranged to receive data defining an image to be rendered on the building; this may include simply consist of storing a plurality of images to be displayed and the times at which the images are to be displayed. The coordinator determines the state of each of the plurality of displays necessary to render the image to be displayed, and transmits to each of the tiles data required for that display to adopt the state necessary to render the image. Typically, the necessary data transfer will be effected in a manner which will be familiar to anyone familiar with networking or internet technology: the coordinator transmits a series of packages of information with each package containing an address portion identifying the tile for which it is intended, and a data portion specifying the image to be displayed on that tile. Each tile "listens" to all packages put only acts in response to packages bearing its own address. (In the case of the cluster tree and mesh topologies described below, in which some tiles communicate with the coordinator only via other "switching" tiles, each switching tile must of course receive not only its own data but also those of all the tiles which receive their data through it.) The address portion of each package may be a serial number or similar unique identifier of a particular tile; this allows for relative easy replacement of a damaged, destroyed or malfunctioning tile, since it only necessary to advise the coordinator of the serial numbers etc. of the replaced and the new tile.

As illustrated in Figures 7A-7C, there can be different styles of network topologies, such as star, mesh and cluster tree. Mesh network topology is generally preferred due to the high reliability offered. Each transmitter can have multiple paths to connect to its receiver. The aforementioned LTC5800 family is both capable of low power consumption and mesh network topology due to timing synchronization. This allows each transmitter to send data at a prescribed time slot, and run in a low power or sleep mode the rest of the time. The timing accuracy is also relevant for synchronized event management. Specifically an update event can be pre-scheduled with multiple transceivers in order to have an aggregate update occur, even if there is low frequency bandwidth available. Typically Bluetooth Low energy is operated in a Star-network topology, but if running networking firmware from "Wirepas" the Bluetooth low energy chipset can run in a mesh topology with synchronized sleep for low power consumption. Also, there is also an "internet of things" (IoT) open source application called "ConTiki" which can be run on a number of hardware platforms, including the CC2530 chip set from Texas Instruments. This networking suite allows multiple styles of timing synchronization, allowing low power mesh networking through coordinated sleep times.

Figure 8 is a front view of part of a display (generally designated 800) of the present invention which uses a two-part weatherproof envelope; the portion of the display shown in Figure 8 corresponds to the topmost portion of Figure 2 but is inverted relative to Figure 2. The main portion of the display 800 has a structure similar to that shown in Figure 3, and comprises an electrophoretic layer 826 provided with upper and lower electrodes (not shown). Two upper contact pads 828 make contact with the upper electrode and two lower contact pads 830 make contact with the lower electrode. Two photovoltaic arrays 832, 834 form the power generation means of the display. All of the aforementioned components of the display are sealed within a first weatherproof envelope formed by front and rear protective stacks similar to those shown in Figure 3 and joined to form an edge seal 806. However, the front protective stack is provided with apertures which expose four separate contact pads 840, 842, 844 and 846 near one edge of the display 800. As indicated schematically, the two photovoltaic arrays 832, 834 are connected to contact pads 840 and 842, the two upper contact pads 828 are connected to contact pad 844 and the two lower contact pads 830 are connected to contact pad 846.

A printed circuit board 848 (indicated only schematically in Figure 8) carries control circuitry and a supercapacitor (neither shown) and overlies the contact pads 840, 842, 844 and 846. Contacts (not shown) on the lower surface of PCB 848 make electrical contact with the contact pads 840, 842, 844 and 846. PCB 848 is potted using a cured resin which extends into contact with the front surface of the front protective stack, thus forming a weatherproof enclosure around PCB 848 and sealing the apertures adjacent contact pads 840, 842, 844 and 846. An antenna 850 (indicated only schematically in Figure 8) extends through the potting material to allow unhindered reception of data from a control center (not shown).

The displays and display systems of the present invention have been described above largely with reference to electrophoretic electro-optic media. Particle-based electrophoretic display, in which a plurality of charged particles move through a fluid under the influence of an electric field, have been the subject of intense research and development for a number of years. Electrophoretic displays can have attributes of good brightness and contrast, wide viewing angles, state bistability, and low power consumption when compared with liquid crystal displays. Nevertheless, problems with the long-term image quality of these displays have prevented their widespread usage. For example, particles that make up electrophoretic displays tend to settle, resulting in inadequate service-life for these displays.

As noted above, electrophoretic media require the presence of a fluid. In most prior art electrophoretic media, this fluid is a liquid, but electrophoretic media can be produced using gaseous fluids; see, for example, Kitamura, T., et al., "Electrical toner movement for electronic paper-like display", IDW Japan, 2001, Paper HCS1-1, and Yamaguchi, Y, et al., "Toner display using insulative particles charged triboelectrically", IDW Japan, 2001, Paper AMD4-4). See also U.S. Patents Nos. 7,321,459 and 7,236,291. Such gas-based electrophoretic media appear to be susceptible to the same types of problems due to particle settling as liquid-based electrophoretic media, when the media are used in an orientation which permits such settling, for example in a sign where the medium is disposed in a vertical plane. Indeed, particle settling appears to be a more serious problem in gas-based electrophoretic media than in liquid-based ones, since the lower viscosity of gaseous suspending fluids as compared with liquid ones allows more rapid settling of the electrophoretic particles.

Numerous patents and applications assigned to or in the names of the Massachusetts Institute of Technology (MIT), E Ink Corporation, E Ink California, LLC. and related companies describe various technologies used in encapsulated and microcell electrophoretic and other electro-optic media. Encapsulated electrophoretic media comprise numerous small capsules, each of which itself comprises an internal phase containing electrophoretically-mobile particles in a fluid medium, and a capsule wall surrounding the internal phase. Typically, the capsules are themselves held within a polymeric binder to form a coherent layer positioned between two electrodes. In a microcell electrophoretic display, the charged particles and the fluid are not encapsulated within microcapsules but instead are retained within a plurality of cavities formed within a carrier medium, typically a polymeric film. The technologies described in these patents and applications include:
(a) Electrophoretic particles, fluids and fluid additives; see for example U.S. Patents Nos. 7,002,728; and 7,679,814;
(b) Capsules, binders and encapsulation processes; see for example U.S. Patents Nos. 6,922,276; and 7,411,719;
(c) Microcell structures, wall materials, and methods of forming microcells; see for example United States Patent No. 7,072,095; and U.S. Patent Application Publication No. 2014/0065369;
(d) Methods for filling and sealing microcells; see for example United States Patent No. 7,144,942; and U.S. Patent Application Publication No. 2008/0007815;
(e) Films and sub-assemblies containing electro-optic materials; see for example U.S. Patents Nos. 6,982,178; and 7,839,564;
(f) Backplanes, adhesive layers and other auxiliary layers and methods used in displays; see for example U.S. Patents Nos. 7,116,318; and 7,535,624;
(g) Color formation and color adjustment; see for example U.S. Patents Nos. 7,075,502; and 7,839,564;
(h) Methods for driving displays; see for example U.S. Patents Nos. 7,012,600; and 7,453,445;
(i) Applications of displays; see for example U.S. Patents Nos. 7,312,784; and 8,009,348; and
(j) Non-electrophoretic displays, as described in U.S. Patent No. 6,241,921; and U.S. Patent Application Publication No. 2015/0277160; and applications of encapsulation and microcell technology other than displays; see for example United States Patent No. 7,615,325; and U.S. Patent Application Publications Nos. 2015/0005720 and 2016/0012710.

Many of the aforementioned patents and applications recognize that the walls surrounding the discrete microcapsules in an encapsulated electrophoretic medium could be replaced by a continuous phase, thus producing a so-called polymer-dispersed electrophoretic display, in which the electrophoretic medium comprises a plurality of discrete droplets of an electrophoretic fluid and a continuous phase of a polymeric material, and that the discrete droplets of electrophoretic fluid within such a polymer-dispersed electrophoretic display may be regarded as capsules or microcapsules even though no discrete capsule membrane is associated with each individual droplet; see for example, the aforementioned U.S. Patent No. 6,866,760. Accordingly, for purposes of the present application, such polymer-dispersed electrophoretic media are regarded as sub-species of encapsulated electrophoretic media.

Although electrophoretic media are often opaque (since, for example, in many electrophoretic media, the particles substantially block transmission of visible light through the display) and operate in a reflective mode, many electrophoretic displays can be made to operate in a so-called "shutter mode" in which one display state is substantially opaque and one is light-transmissive. See, for example, U.S. Patents Nos. 5,872,552; 6,130,774; 6,144,361; 6,172,798; 6,271,823; 6,225,971; and 6,184,856. Dielectrophoretic displays, which are similar to electrophoretic displays but rely upon variations in electric field strength, can operate in a similar mode; see U.S. Patent No. 4,418,346. Other types of electro-optic displays may also be capable of operating in shutter mode. Electro-optic media operating in shutter mode may be useful in multi-layer structures for full color displays; in such structures, at least one layer adjacent the viewing surface of the display operates in shutter mode to expose or conceal a second layer more distant from the viewing surface.

An encapsulated electrophoretic display typically does not suffer from the clustering and settling failure mode of traditional electrophoretic devices and provides further advantages, such as the ability to print or coat the display on a wide variety of flexible and rigid substrates. (Use of the word "printing" is intended to include all forms of printing and coating, including, but without limitation: pre-metered coatings such as patch die coating, slot or extrusion coating, slide or cascade coating, curtain coating; roll coating such as knife over roll coating, forward and reverse roll coating; gravure coating; dip coating; spray coating; meniscus coating; spin coating; brush coating; air knife coating; silk screen printing processes; electrostatic printing processes; thermal printing processes; ink jet printing processes; electrophoretic deposition (See U.S. Patent No. 7,339,715); and other similar techniques.) Thus, the resulting display can be flexible. Further, because the display medium can be printed (using a variety of methods), the display itself can be made inexpensively.

Other types of electro-optic materials may also be used in the present invention. One type of electro-optic display is a rotating bichromal member type as described, for example, in U.S. Patents Nos. 5,808,783; 5,777,782; 5,760,761; 6,054,071 6,055,091; 6,097,531; 6,128,124; 6,137,467; and 6,147,791 (although this type of display is often referred to as a "rotating bichromal ball" display, the term "rotating bichromal member" is preferred as more accurate since in some of the patents mentioned above the rotating members are not spherical). Such a display uses a large number of small bodies (typically spherical or cylindrical) which have two or more sections with differing optical characteristics, and an internal dipole. These bodies are suspended within liquid-filled vacuoles within a matrix, the vacuoles being filled with liquid so that the bodies are free to rotate. The appearance of the display is changed by applying an electric field thereto, thus rotating the bodies to various positions and varying which of the sections of the bodies is seen through a viewing surface. This type of electro-optic medium is typically bistable.

Another type of electro-optic display uses an electrochromic medium, for example an electrochromic medium in the form of a nanochromic film comprising an electrode formed at least in part from a semi-conducting metal oxide and a plurality of dye molecules capable of reversible color change attached to the electrode; see, for example O'Regan, B., et al., Nature 1991, *353*, 737; and Wood, D., Information Display, *18(3)*, 24 (March 2002). See also Bach, U., et al., Adv. Mater., 2002, *14(11)*, 845. Nanochromic films of this type are also described, for example, in U.S. Patents Nos. 6,301,038; 6,870,657; and 6,950,220. This type of medium is also typically bistable.

Another type of electro-optic display is an electro-wetting display developed by Philips and described in Hayes, R.A., et al., "Video-Speed Electronic Paper Based on Electrowetting", Nature, 425, 383-385 (2003). It is shown in U.S. Patent No. 7,420,549 that such electro-wetting displays can be made bistable.

Some electro-optic materials are solid in the sense that the materials have solid external surfaces, although the materials may, and often do, have internal liquid- or gas-filled spaces. Such displays using solid electro-optic materials may hereinafter for convenience be referred to as "solid electro-optic displays". Thus, the term "solid electro-optic displays" includes rotating bichromal member displays, encapsulated electrophoretic displays, microcell electrophoretic displays and encapsulated liquid crystal displays.

From the foregoing, it will be seen that the present invention can provide a lightweight, flexible, low power alternative to other outdoor display media like LED and LCD signs. The present invention enables dynamic changing of a building façade or other large element with minimal wiring expense and simplified installation.

## Claims

1. A display (100; 200; 800) comprising:
a weatherproof housing (312, 346);
a bistable electro-optic medium (326) enclosed within the housing (312, 346) and visible through the housing (312, 346);
at least one electrode (324, 330) enclosed within the housing (312, 346) and arranged to apply an electric field to the bistable electro-optic medium (326),
a power generating means (504; 832, 834) enclosed within the weatherproof housing (312, 346); and
display drive means (510) arranged to receive power from the power generating means (504), and to control the potentials of the at least one electrode (324, 330),
the display (800) being **characterized by** data receiving means (508) enclosed within the weatherproof housing (312, 346) and arranged to receive data wirelessly from a source outside the weatherproof housing (312, 346), the display drive means (510) being arranged to receive data from the data receiving means (508), the weatherproof housing conforming closely to the components therein such that no air gap of more than about 5 millimeters exists between the weatherproof housing and its contents, the weatherproof housing having a main section and a second section, the main section enclosing the electro-optic medium (826) and the power generating means (832, 834), the main section having at least one aperture which exposes a plurality of electrical contact pads (842, 842, 844, 846), the second section housing at least one printed circuit board (848) comprising the display drive means and overlying the at least one aperture, the second section also housing conductors which make electrical contact with the exposed electrical contact pads (842, 842, 844, 846), and the second section covering the exposed electrical contact pads (842, 842, 844, 846), the at least one printed circuit board being covered in a weatherproof material which extends to the main section so that the weatherproof material seals the at least one aperture in the main section.

2. A display according to claim 1 wherein an external surface of the weatherproof housing (312, 346) is provided with an adhesive layer (602, 604) capable of attaching the display to the surface of a building.

3. A display according to claim 1 wherein the weatherproof housing (312, 346) conforms closely to the components enclosed therein, such that no air gap of more than about 1 mm exists between the weatherproof housing (312, 346) and its contents.

4. A display according to claim 1 further comprising power storage means (506) to allow the display to continue to function when the power generating means (504) is not generating sufficient power for the requirements of the display.

5. A display according to claim 4 wherein the power storage means (506) comprises a supercapacitor.

6. A display according to claim 1 wherein the bistable electro-optic medium (326) comprises an electrophoretic medium comprising a plurality of charged particles dispersed in a fluid and capable of moving through the fluid when the at least one electrode applies an electric field to the electrophoretic medium.

7. A display according to claim 6 wherein the electrophoretic medium (326) is an encapsulated, microcell or polymer-dispersed electrophoretic medium.

8. A display according to claim 1 wherein the bistable electro-optic medium is a rotating bichromal member, electrochromic or electro-wetting medium.

9. A building equipped with a display system, **characterized in that** the display system comprises:
a plurality of displays (100; 200; 800) according to claim 1, each disposed on a surface of the building; and
control means arranged to receive data defining an image to be rendered on the building, to determine the state of each of the plurality of displays necessary to render said image, and to transmit to each of the plurality of displays data required for that display to adopt the state necessary to render the image.

## Patentansprüche

1. Anzeige (100; 200; 800), umfassend:
ein wetterfestes Gehäuse (312, 346);
ein bistabiles elektrooptisches Medium (326), das innerhalb des Gehäuses (312, 346) enthalten und durch das Gehäuse (312, 346) sichtbar ist;
mindestens eine Elektrode (324, 330), die innerhalb des Gehäuses (312, 346) enthalten und zum Anlegen eines elektrischen Feldes an das bistabile elektrooptische Medium (326) ausgelegt ist,
ein Leistungserzeugungsmittel (504; 832, 834), das innerhalb des wetterfesten Gehäuses (312, 346) enthalten ist; und
Anzeigeansteuermittel (510), die zum Empfangen von Leistung vom Leistungserzeugungsmittel (504) und zum Steuern der Potenziale der mindestens einen Elektrode (324, 330) ausgelegt sind,
wobei die Anzeige (800) durch Datenempfangsmittel (508) gekennzeichnet ist, die innerhalb des wetterfesten Gehäuses (312, 346) enthalten und zum drahtlosen Empfangen von Daten von einer Quelle außerhalb des wetterfesten Gehäuses (312, 346) ausgelegt sind, wobei die Anzeigeansteuermittel (510) zum Empfangen von Daten von den Datenempfangsmitteln (508) ausgelegt sind, das wetterfeste Gehäuse sich eng an die Komponenten darin anpasst, derart dass kein Luftspalt von mehr als etwa 5 Millimeter zwischen dem wetterfesten Gehäuse und seinen Inhalten besteht, das wetterfeste Gehäuse einen Hauptabschnitt und einen zweiten Abschnitt umfasst, der Hauptabschnitt das elektrooptische Medium (826) und das Leistungserzeugungsmittel (832, 834) enthält, der Hauptabschnitt mindestens eine Öffnung aufweist, die eine Mehrzahl von elektrischen Kontaktstellen (842, 842, 844, 846) freilegt, der zweite Abschnitt mindestens eine gedruckte Leiterplatte (848) beherbergt, welche die Anzeigeansteuermittel umfasst und die mindestens eine Öffnung überlagert, der zweite Abschnitt außerdem Leiter beherbergt, die elektrischen Kontakt mit den freiliegenden elektrischen Kontaktstellen (842, 842, 844, 846) herstellen, und der zweite Abschnitt die freiliegenden elektrischen Kontaktstellen (842, 842, 844, 846) abdeckt, wobei die mindestens eine gedruckte Leiterplatte mit einem wetterfesten Material abgedeckt ist, das sich zum Hauptabschnitt erstreckt, so dass das wetterfeste Material die mindestens eine Öffnung im Hauptabschnitt verschließt.

2. Anzeige nach Anspruch 1, wobei eine Außenfläche des wetterfesten Gehäuses (312, 346) mit einer Haftschicht (602, 604) versehen ist, die zum Befestigen der Anzeige an der Oberfläche eines Gebäudes imstande ist.

3. Anzeige nach Anspruch 1, wobei das wetterfeste Gehäuse (312, 346) sich eng an die darin enthaltenen Komponenten anpasst, derart dass kein Luftspalt von mehr als etwa 1 mm zwischen dem wetterfesten Gehäuse (312, 346) und seinen Inhalten besteht.

4. Anzeige nach Anspruch 1, ferner umfassend Leistungsspeichermittel (506), um zu ermöglichen, dass die Anzeige weiter funktioniert, wenn das Leistungserzeugungsmittel (504) nicht genügend Leistung für die Anforderungen der Anzeige erzeugt.

5. Anzeige nach Anspruch 4, wobei das Leistungsspeichermittel (506) einen Superkondensator umfasst.

6. Anzeige nach Anspruch 1, wobei das bistabile elektrooptische Medium (326) ein elektrophoretisches Medium umfasst, das eine Mehrzahl geladener Teilchen umfasst, die in einem Fluid dispergiert und imstande ist, sich durch das Fluid zu bewegen, wenn die mindestens eine Elektrode ein elektrisches Feld an das elektrophoretische Medium anlegt.

7. Anzeige nach Anspruch 6, wobei das elektrophoretische Medium (326) ein verkapseltes, mikrozell- oder polymerdispergiertes elektrophoretisches Medium ist.

8. Anzeige nach Anspruch 1, wobei das bistabile elektrooptische Medium ein rotierendes bichromes Element, ein elektrochromes oder elektrobenetzendes Medium ist.

9. Gebäude, das mit einem Anzeigesystem ausgestattet ist, **dadurch gekennzeichnet, dass** das Anzeigesystem umfasst:
eine Mehrzahl von Anzeigen (100; 200; 800) nach Anspruch 1, die jeweils auf einer Oberfläche des Gebäudes angeordnet sind; und
Steuermittel, die zum Empfangen von Daten, die ein auf dem Gebäude wiederzugebendes Bild definieren, zum Bestimmen des Zustands einer jeden der Mehrzahl von Anzeigen, die zum Wiedergeben des Bildes notwendig ist, und zum Senden von Daten, die für diese Anzeige erforderlich sind, um den zum Wiedergeben des Bildes notwendigen Zustand anzunehmen, an jede der Mehrzahl von Anzeigen ausgelegt sind.

## Revendications

1. Écran (100 ; 200 ; 800) comprenant :
un boîtier résistant aux intempéries (312, 346) ;
un milieu électro-optique bistable (326) enfermé à l'intérieur du boîtier (312, 346) et visible à travers le boîtier (312, 346) ;
au moins une électrode (324, 330) enfermée à l'intérieur du boîtier (312, 346) et agencée pour appliquer un champ électrique au milieu électro-optique bistable (326) ;
un moyen de production d'énergie (504 ; 832, 834) enfermé à l'intérieur du boîtier résistant aux intempéries (312, 346) ; et
des moyens de commande d'affichage (510) agencés pour recevoir de l'énergie depuis le moyen de production d'énergie (504), et pour contrôler les potentiels de l'au moins une électrode (324, 330),
l'écran (800) étant **caractérisé par** des moyens de réception de données (508) enfermés à l'intérieur du boîtier résistant aux intempéries (312, 346) et agencés pour recevoir des données sans fil depuis une source à l'extérieur du boîtier résistant aux intempéries (312, 346), les moyens de commande d'affichage (510) étant agencés pour recevoir des données depuis les moyens de réception de données (508), le boîtier résistant aux intempéries épousant étroitement la forme des composants à l'intérieur de telle sorte qu'aucune lame d'air de plus d'environ 5 millimètres n'existe entre le boîtier résistant aux intempéries et son contenu, le boîtier résistant aux intempéries ayant une section principale et une deuxième section, la section principale enfermant le milieu électro-optique (826) et le moyen de production d'énergie (832, 834), la section principale ayant au moins une ouverture qui expose une pluralité de plots de contact électrique (842, 842, 844, 846), la deuxième section abritant au moins une carte de circuit imprimé (848) comprenant les moyens de commande d'affichage et recouvrant l'au moins une ouverture, la deuxième section abritant également des conducteurs qui font contact électrique avec les plots de contact électrique exposés (842, 842, 844, 846), et la deuxième section recouvrant les plots de contact électrique exposés (842, 842, 844, 846), l'au moins une carte de circuit imprimé étant recouverte par un matériau résistant aux intempéries qui s'étend jusqu'à la section principale de telle sorte que le matériau résistant aux intempéries scelle l'au moins une ouverture dans la section principale.

2. Écran selon la revendication 1 dans lequel une surface externe du boîtier résistant aux intempéries (312, 346) est pourvue d'une couche adhésive (602, 604) pouvant fixer l'écran à la surface d'un bâtiment.

3. Écran selon la revendication 1 dans lequel le boîtier résistant aux intempéries (312, 346) épouse étroitement la forme des composants enfermés à l'intérieur, de telle sorte qu'aucune lame d'air de plus d'environ 1 mm n'existe entre le boîtier résistant aux intempéries (312, 346) et son contenu.

4. Écran selon la revendication 1 comprenant en outre des moyens de stockage d'énergie (506) pour permettre à l'écran de continuer à fonctionner quand le moyen de production d'énergie (504) ne produit pas suffisamment d'énergie pour les besoins de l'écran.

5. Écran selon la revendication 4 dans lequel les moyens de stockage d'énergie (506) comprennent un supercondensateur.

6. Écran selon la revendication 1 dans lequel le milieu électro-optique bistable (326) comprend un milieu électrophorétique comprenant une pluralité de particules chargées dispersées dans un fluide et pouvant se déplacer à travers le fluide quand l'au moins une électrode applique un champ électrique au milieu électrophorétique.

7. Écran selon la revendication 6 dans lequel le milieu électrophorétique (326) est un milieu électrophorétique encapsulé, à microcellules ou dispersé dans un polymère.

8. Écran selon la revendication 1 dans lequel le milieu électro-optique bistable est un milieu à élément bichrome rotatif, électrochrome ou électromouillant.

9. Bâtiment équipé d'un système d'affichage, **caractérisé en ce que** le système d'affichage comprend :
une pluralité d'écrans (100 ; 200 ; 800) selon la revendication 1, chacun disposé sur une surface du bâtiment ; et
des moyens de contrôle agencés pour recevoir des données définissant une image devant être rendue sur le bâtiment, pour déterminer l'état de chacun de la pluralité d'écrans nécessaire pour effectuer le rendu de ladite image, et pour transmettre à chacun de la pluralité d'écrans des données nécessaires pour que cet écran adopte l'état nécessaire pour effectuer le rendu de l'image.
